# EUROPEAN PATENT APPLICATION

(11) **EP 3 203 816 A1**
(43) Date of publication of application: **09.08.2017**
(21) Application number: 15846149.1
(22) Date of filing: 31.08.2015
(51) Int. Cl.: H05K 3/12, B41M 1/04, B41M 1/30, B41F 3/20, B41F 17/14

(54) **METHOD FOR MANUFACTURING ELECTRONIC CIRCUIT SUBSTRATE, AND ELECTRONIC CIRCUIT SUBSTRATE OBTAINED THEREBY**

(30) Priority: 03.10.2014 JP 2014204612
(71) Applicant: Komura-tech Co., Ltd., Higashi-Osaka-shi, Osaka 579-8014 (JP)
(72) Inventor: KANEHARA, Masayuki, Soja-shi Okayama 7191121 (JP); URANO, Masaaki, Higashi-Osaka-shi Osaka 579-8014 (JP)
(74) Representative: Kuhnen & Wacker
(86) International application number: PCT/JP2015/074627
(87) International publication number: WO 2016/052043

(57) **Abstract**

An electronic circuit board manufacturing method according to the present disclosure is a method of manufacturing an electronic circuit board including a substrate and an electronic circuit having a predetermined pattern, the electronic circuit being fixed on the substrate and being made from a nanoink composition containing metal particles. The method includes the steps of: causing a printing plate to hold a nanoink composition containing metal particles, the printing plate including an ink holding part formed on a surface thereof and having a predetermined pattern; bringing a surface of the substrate into intimate contact with the printing plate to transfer the nanoink composition held on the ink holding part onto the substrate (workpiece W); and drying the transferred nanoink composition in an environment of 40°C or below in the atmosphere to fix the nanoink composition after the transfer step, thereby forming an electronic circuit having a predetermined pattern. This method is capable of forming a layer made from a uniform nanoink composition rapidly and efficiently at ordinary temperatures and under atmospheric pressure.

## Description

### TECHNICAL FIELD

The present disclosure relates to an electronic circuit board manufacturing method which uses an electrically conductive ink to form an electronic circuit on a substrate at ordinary temperatures, and an electronic circuit board obtained by the same.

### BACKGROUND ART

Printed electronics which use printing technology to form electronic elements, electronic circuits and the like are achieved by applying (printing or transferring) high-performance materials (metals, semiconductor materials and the like) in the form of ink onto a surface of a substrate (board) to form a pattern. This method, which does not require any large-scale expensive manufacturing apparatus such as a vacuum apparatus, has been receiving attention in recent years as a technique capable of forming large-area elements and element boards at low costs. Unfortunately, conventional printed electronics processes, which include a heating process at a temperature reaching 100°C to 200°C or higher for the firing of the high-performance materials, have been disadvantageous in that a substrate which thermally expands and contracts such as a film made of resin cannot be used for the board.

The present inventors have developed an electrically conductive ink (nanoink composition) requiring no firing after the application thereof, and have already applied for patent (see PTL 1). This nanoink composition includes a particular "aromatic molecule having electrical conductivity" as a ligand of a metal nanoparticle. The use of the aforementioned nanoink composition allows all of the application processes to be performed in the atmosphere at ordinary temperatures, thereby forming electronic elements, electronic circuits and the like without an increase in temperature. In the case of printing an electronic circuit and the like on a flexible substrate such as a film made of resin, the use of the aforementioned nanoink composition which requires no heating and firing process allows all of the manufacturing steps to be performed at ordinary temperatures. This suppresses the thermal deformation of the substrate and the like to achieve high-precision transfer of a microscopic circuit.

### RELATED ART DOCUMENT

### PATENT DOCUMENT

PTL 1: WO 2011/114713

### SUMMARY OF INVENTION

Unfortunately, only a printing method based on an inkjet technique is established under the current circumstances as the application method using the aforementioned nanoink composition to mass-produce microscopic electronic circuits with high precision and with high reproducibility on a flexible substrate. This printing method is not necessarily efficient. It is therefore required to develop an ink application method employing the aforementioned nanoink composition with high production efficiency.

In view of the foregoing, it is therefore an object of the present disclosure to provide an electronic circuit board manufacturing method capable of applying a uniform nanoink composition rapidly and efficiently at ordinary temperatures and under atmospheric pressure, and an electronic circuit board obtained by the same.

To accomplish the aforementioned object, a first aspect of the present disclosure is intended for a method of manufacturing an electronic circuit board including a substrate and an electronic circuit having a predetermined pattern, the electronic circuit being fixed on the substrate and being made from a nanoink composition containing metal particles. The method comprises the steps of: holding a nanoink composition containing metal particles on a printing plate, the printing plate including an ink holding part formed on a surface thereof and having a predetermined pattern; bringing a surface of the substrate into intimate contact with the printing plate to transfer the nanoink composition held on the ink holding part onto the substrate; and drying the transferred nanoink composition in an environment of 40°C or below in atmospheric pressure to fix the nanoink composition after the transfer step, thereby forming an electronic circuit having a predetermined pattern. A second aspect of the present disclosure is intended for an electronic circuit board provided by the method.

Specifically, the present inventors have repeatedly considered solutions to the aforementioned problem using an easy method other than the inkjet technique in place of the method requiring a large-scale apparatus such as the aforementioned vacuum apparatus and the like, and have hit upon the idea of achieving the solution through the use of transfer printing employing a plate. Then, the present inventors have repeated one trial and error after another for printing plates and properties of the substrate that is an object being printed on. As a result, the present inventors have found that a relatively thick nanoink composition layer is formed in conformity with a predetermined pattern efficiently without unevenness on the substrate by causing a printing plate including a patterned ink holding part on the surface of the plate to hold a aqueous nanoink composition and then bringing the plates into intimate contact with the surface of the flexible substrate to transfer the aqueous nanoink composition onto the substrate. Hence, the present inventors have attained the present disclosure.

The "printing plate including the patterned ink holding part on the surface of the plate" may be any one selected from a letterpress plate, an intaglio plate and a planographic plate. A printing method that can "transfer the nanoink composition" as used herein may be any one selected from: letterpress printing such as typographic printing and flexographic printing; intaglio printing such as gravure printing; and planographic printing such as offset printing and gravure-offset printing, with the exception of stencil printing represented by screen printing.

The method of manufacturing an electronic circuit board according to the present disclosure includes the steps of: holding a nanoink composition on a printing plate; transferring the nanoink composition held on the printing plate onto a substrate; and drying the transferred nanoink composition in an environment of 40°C or below in atmospheric pressure to fix the nanoink composition. The provision of these steps allows a uniform layer made from the nanoink composition to be formed on the surface of the substrate precisely and efficiently with stability in conformity with the predetermined pattern without providing such excessive heat as to cause the expansion and contraction of the substrate, even in the case where the "heat-sensitive" flexible substrate is used.

The method of manufacturing an electronic circuit board according to the present disclosure includes not only transferring the nanoink composition having the predetermined pattern only once but also transferring the nanoink composition a plurality of times (repeatedly several times) in a stacked manner on the same region of the substrate. When the nanoink composition is transferred a plurality of times, whether the nanoink composition is dried (fixed) for each transfer operation or the nanoink composition transferred a plurality of times in a stacked manner is dried at a one time only may be selected as appropriate depending on the surface condition of the substrate after the transfer.

When a film made of paper or resin is used as the substrate in the electronic circuit board manufacturing method according to the present disclosure, the method is capable of forming a uniform electronic circuit made from the nanoink composition precisely in conformity with the predetermined pattern on such a substrate which "thermally expands and contracts significantly" and is accordingly difficult to handle by other manufacturing methods.

Further, when a contact angle of water on the surface of the substrate is not greater than 30 degrees in the electronic circuit board manufacturing method according to the present disclosure, the transferred nanoink composition is absorbed and dried more rapidly. Thus, the method is capable of forming the predetermined pattern more precisely and more finely.

Furthermore, when the content of the metal particles in the nanoink composition is in the range of 0.1 to 20 wt.% in the electronic circuit board manufacturing method according to the present disclosure, the method is capable of forming a uniform electronic circuit having a smooth surface and a sufficient thickness. When the content of the metal particles in the nanoink composition is either less than 0.1 wt.% or greater than 20 wt.%, it is impossible to form a uniform and smooth nanoink composition layer, and there is apprehension that the formed electronic circuit has a rough surface.

In particular, when the metal particles in the nanoink composition are nanometer-size silver particles in the electronic circuit board manufacturing method according to the present disclosure, the method is capable of manufacturing an electronic circuit of balanced quality at low costs with high reproducibility because of excellent long-term storage stability in the state of the nanoink composition.

Further, when the printing plate is a flexographic printing plate in the electronic circuit board manufacturing method according to the present disclosure, the method is capable of forming an electronic circuit having a sufficient thickness with efficiency by transferring the nanoink composition a smaller number of times because the amount of nanoink composition held on the printing plate (the amount of nanoink composition transferred at a time) is large.

In an electronic circuit board obtained by the aforementioned electronic circuit board manufacturing method, an electronic circuit having a practically sufficient thickness and electrical conductivity is formed precisely in conformity with a predetermined pattern on the surface of the substrate without any heating and firing step which causes the expansion and contraction of the flexible substrate. Also, the aforementioned vacuum apparatus and a large-scale apparatus such as an oven for the heating and firing are not required for the manufacture of the electronic circuit board. Thus, the electronic circuit board is manufactured with a small initial investment at low running costs.

### BRIEF DESCRIPTION OF DRAWINGS

[FIG. 1] FIG. 1 is a schematic view showing the configuration of a flexographic printing press for use in an electronic circuit board manufacturing method according to an embodiment of the present disclosure before the start of the transfer of a nanoink composition.
[FIG. 2] FIG. 2 is a view showing the nanoink composition held on a flexographic printing plate of the flexographic printing press according to the embodiment of the present disclosure.
[FIG. 3] FIG. 3 is a view showing the nanoink composition transferred from the flexographic printing plate to an obj ect being printed on (workpiece W) according to the embodiment of the present disclosure.
[FIG. 4] FIG. 4 is a view showing the nanoink composition transferred to the object being printed on (workpiece W) a plurality of times according to the embodiment of the present disclosure.
[FIG. 5] FIG. 5A is an enlarged plan view of a nanoink composition holding part of the flexographic printing plate for use in the electronic circuit board manufacturing method according to the embodiment of the present disclosure, and FIG. 5B is a sectional view taken along the line X-X' of FIG. 5A.

### DESCRIPTION OF EMBODIMENTS

Next, an embodiment according to the present disclosure will now be described in detail with reference to the drawings. It should be noted that the thicknesses of a printing plate and a nanoink composition (layer) in each figure are shown in exaggeration.

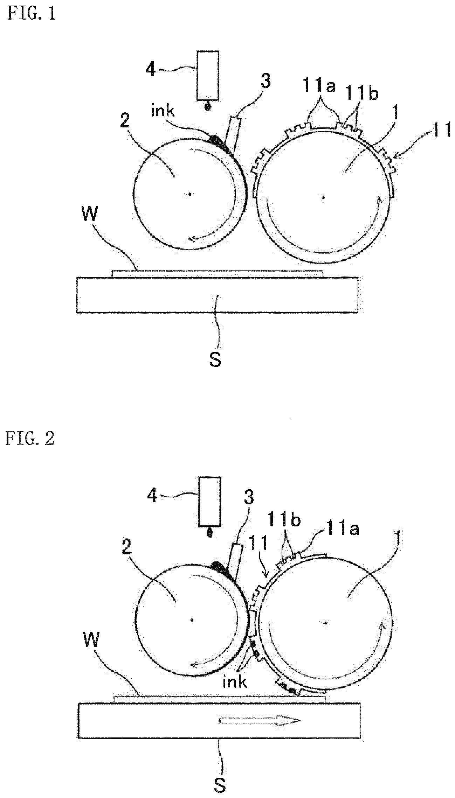

First, a flexographic printing press for use in a method of manufacturing an electronic circuit board according to the present embodiment will be described briefly. FIG. 1 is a schematic view showing the configuration of the flexographic printing press for use in the present embodiment. In FIG. 1, the reference numeral 1 designates a plate cylinder; 2 designates an anilox roll; 3 designates a squeegee; 4 designates an ink tank for storing a nanoink composition therein; and the reference character S designates a movable stage for placing thereon an object being printed on (workpiece W). The plate cylinder 1 has an outer periphery (peripheral surface) to which a flexographic printing plate (abbreviated hereinafter as a "printing plate") 11 having an ink holding part is attached (the same applies to FIGS. 2 to 4).

The anilox roll 2 and the plate cylinder 1 rotate in synchronism with each other while holding the nanoink composition, which will be described later. The movable stage S moves (slides) in synchronism with the rotation of the plate cylinder 1 while the nanoink composition is transferred.

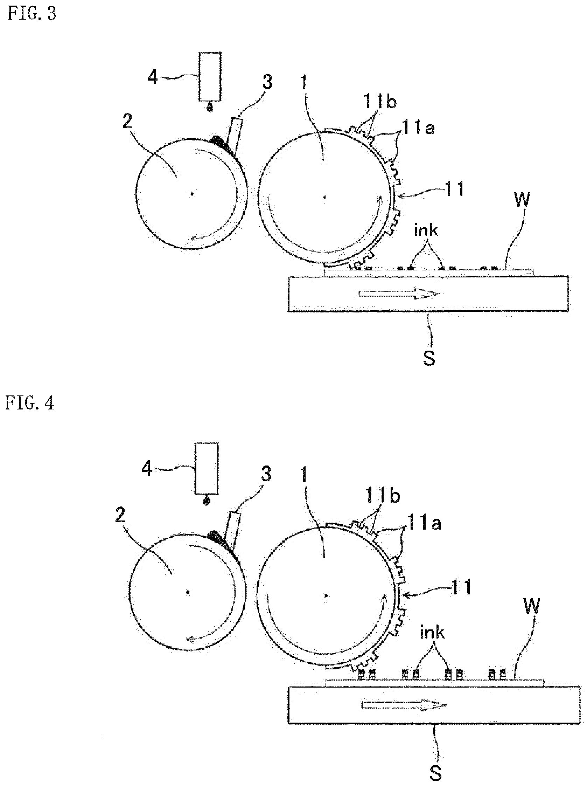

As shown in FIGS. 1 to 4, the electronic circuit board manufacturing method according to the present embodiment using the flexographic printing press forms an electronic circuit made from a nanoink composition (solidly shaded area designated by "ink" in the figures) on one surface of a flexible film substrate (workpiece W that is an object being printed on). The electronic circuit board manufacturing method includes the steps of: (A) holding the nanoink composition containing metal particles on the printing plate 11, the printing plate 11 including the ink holding part (protrusions 11a having microscopic recesses 11b in their top surfaces) formed on a surface thereof and having a predetermined pattern [FIG. 1 → FIG. 2] ; (B) bringing the surface of the workpiece W into intimate contact with the printing plate 11 to transfer the nanoink composition held on the ink holding part onto the workpiece W [FIG. 2 → FIG. 3] ; and (C) drying the transferred nanoink composition in an environment of 40°C or below in the atmosphere to fix the nanoink composition after the transfer step, thereby forming an electronic circuit having a predetermined pattern [not shown].

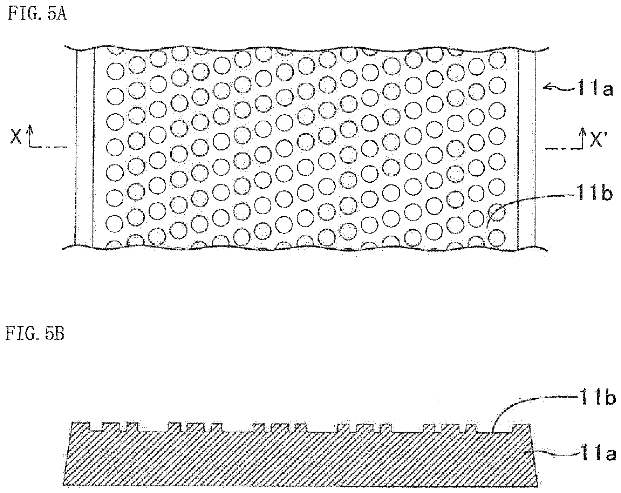

More specifically, the preparatory step prior to printing (transfer) includes: wrapping and fixing the printing plate 11 in a predetermined position around the outer peripheral surface of the plate cylinder 1, the printing plate 11 including the ink holding part formed on the surface (upper surface) thereof and having a predetermined pattern (with reference to FIG. 5), as shown in FIG. 1; and charging a predetermined nanoink composition (nanosilver colloidal ink known under the trade name of DryCure available from Colloidal Ink Co., Ltd.) into the ink tank 4 provided in corresponding relation to the anilox roll 2 including the squeegee 3. Then, the film substrate (workpiece W) made of paper, resin or the like and having a surface (printing surface) previously surface-treated to improve water absorbency is placed and prepared in a predetermined position on the movable stage S.

The nanosilver colloidal ink may be always stored in the ink tank 4 because of its excellent storage stability. When the surroundings of the flexographic printing press including the surroundings of the plate cylinder 1 are controlled to a humidified atmosphere of not less than 60% RH through the use of a humidifier, an air conditioner or the like prior to the start of the manufacture, the nanosilver colloidal ink is prevented from being inadvertently dried on the printing plate 11.

Next, the step (A) of holding the nanoink composition on the printing plate 11 will be described. In the step (A), the nanosilver colloidal ink is initially supplied from the ink tank 4 at predetermined time intervals, with the anilox roll 2 rotated, and the squeegee 3 is used to form a liquid film of the nanosilver colloidal ink having a predetermined thickness on the outer peripheral surface of the anilox roll 2, as shown in FIG. 1. In that state, the plate cylinder 1 and the anilox roll 2 are rotated in synchronism with each other to bring the printing plate 11 into contact with the nanosilver colloidal ink, thereby causing the ink holding part (protrusions 11a having the microscopic recesses 11b in their top surfaces) of the printing plate 11 to hold the nanosilver colloidal ink thereon, as shown in FIG. 2.

Subsequently, the step (B) of transferring the nanoink composition onto the workpiece W will be described. In the step (B), while the printing plate 11 is rotated together with the plate cylinder 1, the workpiece W that is the object being printed on is slidingly moved in synchronism with the movable stage S. Thus, the printing plate 11 holding the nanosilver colloidal ink thereon is brought into contact with the surface (printing surface) of the workpiece W at a low printing pressure, known as "kiss-touch", to transfer the nanosilver colloidal ink held in the recesses 11b formed in the top surfaces of the protrusions 11a onto the surface of the workpiece W into a predetermined pattern, as shown in FIG. 3.

Next, the step (C) of drying the transferred nanoink composition in an environment of 40°C or below in the atmosphere to fix the nanoink composition will be described. In the step (C), while the workpiece W having the surface on which the nanosilver colloidal ink is transferred as described above remains placed on the movable stage S or is moved onto another flat place, the nanosilver colloidal ink is fixed (formed into a coating) by drying, so that an electronic circuit board with an electronic circuit in a predetermined pattern formed thereon (the workpiece W with the electronic circuit) is provided.

An air blower, a warm-air drier or the like may be used for the drying, so long as the temperature of the air and the like does not exceed 40°C, to thereby shorten the drying time. Also, so long as the temperature of the workpiece W does not exceed 40°C, indirect irradiation heating methods maybe used such as an infrared lamp, heat rays including a hyperthermia lamp and sunlight, ultrasound, or high-frequency heating including high-frequency current.

If the thickness of the coating made from the nanosilver colloidal ink does not reach an initially set thickness after the drying, the transfer may be repeated using the same processing conditions and the same machine settings, so that coatings made from the nanosilver colloidal ink are stacked on top of each other in the same region in the same pattern, as shown in FIG. 4 (although the film thickness is shown in further exaggeration). Whether the nanosilver colloidal ink is dried for each transfer operation or the nanosilver colloidal ink transferred a plurality of times is dried at a one time only may be selected as appropriate depending on the dried condition and roughness of the surface of the substrate after the transfer.

When a "heat-sensitive" flexible substrate made of paper, resin or the like is used as the object being printed on (workpiece W), the aforementioned electronic circuit board manufacturing method is capable of forming a uniform layer made from the nanosilver colloidal ink (nanoink composition) precisely and efficiently with stability in conformity with the predetermined pattern on the surface of the substrate without providing such excessive heat as to cause the expansion and contraction of the substrate.

The nanoink composition for use in the electronic circuit board manufacturing method according to the present disclosure includes metal nanoparticles (nanometer-size metal particles), an organic π-conjugated (pi-conjugated) ligand and a solvent. A n junction (pi junction) is formed between the metal nanoparticles and the organic π-conjugated (pi-conjugated) ligand, so that the strong π junction (pi junction) and the approach of the particles to each other provide electrical conductivity.

Examples of the metal used for the aforementioned metal nanoparticles include gold, silver, copper, platinum, palladium, nickel, ruthenium, indium and rhodium, which may be used either alone or in combination. The content of the metal nanoparticles in the nanoink composition is preferably in the range of 0.1 to 20 wt.%, more preferably in the range of 0.5 to 10 wt.%. When the content of the metal nanoparticles in the nanoink composition is either less than 0.1 wt.% or greater than 20 wt.%, it is impossible to form a uniform and smooth nanoink composition layer, and there is apprehension that the obtained electronic circuit (layer) has a rough surface.

Examples of the organic π-conjugated (pi-conjugated) ligand constituting the nanoink composition include one or more substituents selected from the group consisting of amino groups, mercapto groups, hydroxyl groups, carboxyl groups, phosphine groups, phosphonic acid groups, halogen groups, selenol groups, sulfide groups and selenoether groups (substituents coordinate to the surface of the metal nanoparticles); and one or more substituents selected from the group consisting of amino groups, alkylamino groups, amide groups, imide groups, phosphonic acid groups, sulfonic acid groups, cyano groups and nitro groups (substituents which make the metal nanoparticles soluble in a hydrous solvent and an alcohol solvent), and their salts. In particular, 2,3,9,10,16,17,23,24-octakis[(2-N,N-dimethylaminoethyl)thio]phthalocyanine (OTAP) and 2,3,11,12,20,21,29,30-octakis[(2-N,N-dimethylaminoethyl)thio]naphthalocyanine (OTAN) are preferably used.

Preferable examples of the solvent constituting the nanoink composition include water, water mixed solvents, alcohol and alcohol mixed solvents. Examples of an ingredient other than water include alcohol, ether, esters, ketones and amides. Preferable examples thereof include alcohols, and more preferable examples thereof include alcohols having 1 to 10 carbon atoms. Of these solvents, particularly preferably used are methanol, ethanol, 2-ethoxyethanol, ethylene glycol and propylene glycol.

The viscosity of the nanoink composition is preferably on the order of 0.001 to 5 Pa·s (1 to 5000 cP), more preferably 0.01 to 4 Pa·s. When the viscosity is either greater than or less than this range, it tends to be difficult to form a fine circuit pattern of the nanoink composition. The viscosity is measured using a viscometer known under the trade name of TVE-22HT available from Toki Sangyo Co. , Ltd. under the conditions of 20°C, a standard rotor (1°34' x R24) and 0.5 to 100 rpm.

A specific example of the nanoink composition preferably used herein includes a nanosilver colloidal ink (known under the trade name of DRYCURE available from Colloidal Ink Co., Ltd.) as mentioned above in consideration of costs, ease of handling, storage stability and the like.

Examples of the substrate used as the object being printed on in the electronic circuit board manufacturing method according to the present disclosure include film substrates made of paper or resin and having a water-absorbing surface (printing surface) as mentioned above. Examples of the treatment for improving the water absorbency of the surface of these substrates used herein include surface treatment methods for improving the hydrophilicity of the substrate surface, such as plasma treatment, corona discharge treatment, soft X-ray irradiation and ultraviolet light irradiation.

A coating may be applied to the surface (printing surface) of the substrate to thereby provide an ink absorbing layer having water absorbency. This ink absorbing layer may be formed by coating with a resin layer (film) containing at least one fine particle selected from the group consisting of silica, kaoline (clay) and alumina through the use of a suitable application method. Examples of the resin preferably used herein for the ink absorbing layer include acrylic resins, polyester resins and polyurethane resins. It is desirable that the ink absorbing layer has a thickness on the order of 10 nm to 100 µm.

In the substrate subjected to the aforementioned surface treatment or the substrate having the surface provided with the ink absorbing layer, estimated performance of the hydrophilicity of the substrate surface after the treatment is preferably set so that the contact angle of water on the surface of the substrate is not greater than 30 degrees, based on water repellency. When the contact angle of water is greater than 30 degrees, the nanoink composition does not penetrate the substrate surface or the ink absorbing layer but spreads horizontally. Thus, it tends to be difficult to form a microscopic circuit pattern of the nanoink composition.

The aforementioned contact angle of water is obtained by measuring a static contact angle with an automatic contact angle meter known under the trade name of DropMaster (DM) 300 available from Kyowa Interface Science Co. , Ltd. through the use of a sessile drop method (θ/2 method; with a dropping amount of 2 µl) using image analysis.

Examples of the material of the substrate used as the object being printed on include soft resins such as polyester resins, polyimide resins and polyamide resins. In addition, rigid resins such as epoxy resins and phenolic resins may be used as the material of the substrate used as the object being printed on although the flexibility of the substrate is impaired. Also, glass and metal may be used when the surface is modified to have water absorbency. Further, materials especially susceptible to heat and materials having properties degraded by special atmospheres, such as films made of leather, skin, artificial skin, dietary fiber and cellulose nanofiber, animal-derived films produced from microorganisms, bacteria and the like, and films derived from plants such as trees and vegetables, may be used as the material of the substrate in the electronic circuit board manufacturing method according to the present disclosure, so long as these materials have water-absorbing surfaces and can maintain a constant film shape.

An example of the printing plate 11 for use in the flexographic printing press according to the present embodiment includes a letterpress printing plate obtained, for example, by irradiating a mixture of a prepolymer of urethane acrylate, acrylate oligomer, acrylate monomer, a photopolymerization inhibitor, a photopolymerization initiator and the like with ultraviolet light through a negative film to cure and mold the mixture.

The protruding ink holding part (protrusions 11a shown in FIGS. 1 to 4) of the ink holding surface of the printing plate 11 has microscopic asperities (with reference to an enlarged plan view of FIG. 5A and a sectional view of FIG. 5B) formed along a circuit pattern having a predetermined shape by the irradiation with ultraviolet light (photolithography) through the negative film. The nanoink composition is held in the microscopic recesses 11b formed between the microscopic asperities. The amount of nanoink composition per unit area held in the ink holding part on the printing plate 11 is approximately 1 to 50 ml/m².

A letterpress printing plate made of "polyester rubber" obtained by irradiating a mixture of a resin composition and an aid such as a photopolymerization initiator with ultraviolet light through a negative film to cure and mold the mixture may be used as the printing plate 11. The surface shape of the obtained printing plate 11 is similar to that shown in FIGS. 5A and 5B. The amount of nanoink composition per unit area held in the ink holding part is approximately 1 to 50 ml/m².

Next, inventive examples will hereinafter be described in conjunction with comparative examples. It should be noted that the present disclosure is not limited to the inventive examples.

### EXAMPLES

In the inventive examples, electronic circuit boards were produced by flexographic printing using a nanosilver colloidal ink (nanoink composition), and electrically conductive performance (electrical resistance: Ω) comparisons were made between the electronic circuit boards. Also, electronic components were mounted on the electronic circuit boards in which electrical continuity was achieved, and these electronic circuit boards were checked for normal circuit operation.

Prior to the transfer of the nanoink composition, substrates having a surface property suitable for the transfer were selected.

### [Selection of Substrate]

Whether a substrate had a surface property suitable for the transfer or not was judged by measuring the "contact angle of water" on the surface of the substrate. The contact angle was measured by measuring a static contact angle with an automatic contact angle meter known under the trade name of DropMaster (DM) 300 available from Kyowa Interface Science Co., Ltd. through the use of a sessile drop method (θ/2 method; with a dropping amount of 2 µl) using image analysis in the aforementioned manner.

### <Types of Substrates>

Two types of substrates were prepared as the substrate used for the aforementioned judgment. The two types of substrates were as follows : photo paper for inkjet printers to be described later (of a thick photographic printing paper type commercially available as coated paper or glossy paper); and films made of polyethylene terephthalate (PET) [with and without a surface coating (ink absorbing layer)].

### [Measurement of Contact Angle of Water]

The photo paper a, the photo paper b, the PET film c (with the coating) and the PET film d (without the coating) were placed on a measuring table (horizontal) of the automatic contact angle meter at room temperature (23°C) under windless conditions. Then, measurements of the contact angle of water were made immediately after water droplets were dropped (0 seconds), 10 seconds thereafter, 60 seconds (1 minute) thereafter and 300 seconds (5 minutes) thereafter. The measurements were made twice for each of the substrates, and the average of the two measurements was used as a result. The results were listed in TABLE 1 below.

**[TABLE 1]**

| Types of substrates | Immediately after dropping | 10 sec. after dropping | 60 sec. after dropping | 300 sec. after dropping |
|---|---|---|---|---|
| Photo paper a | 28.9 | 27.8 | 25.7 | 17.6 |
| Photo paper b | 108.0 | 99.7 | 87.2 | 67.2 |
| PET film c | 68.0 | 65.0 | 55.1 | 39.9 |
| PET film d | 73.5 | 72.5 | 70.5 | 58.8 |

(Contact angles in units of degrees (°))

Based on the results listed in TABLE 1, the photo paper a (available from Seiko Epson Corporation) and the PET film c (with the coating of the ink absorbing layer) were selected as the substrates suitable for the inventive examples of the present disclosure. The aforementioned ink absorbing layer refers to a layer (film) made of cation-containing acrylic resin, and uniformly coats the surface (printing surface) of the film through the use of a bar coater so as to have a thickness of approximately 17 µm.

Next, the electronic circuit boards in Inventive Examples 1 and 2 and Comparative Examples 1 to 3 were produced by flexographic printing. The nanoink composition, a flexographic printing press and printing conditions used for the production of the electronic circuit boards are as follows.

### <Nanoink Composition> (Nanosilver Colloidal Ink)

Silver nanoink known under the trade name of DRYCURE Ag-J available from Colloidal Ink Co., Ltd.
Components: silver particles having a diameter of 1 to 100 nm (average diameter of 15 nm);
organic π-conjugated (pi-conjugated) ligand; and
a solvent containing water as a main component.

| | |
|---|---|
| Solid content: | 10 to 20 wt.% |
| Viscosity: | 5 to 1155 mPa·s |

### <Substrates>

The photo paper a (available from Seiko Epson Corporation and having a thickness of 0.3 mm) and the photo paper b (available from Kokuyo Co. , Ltd. and having a thickness of 0.3 mm) were prepared as the substrates made of paper.

The PET film c [including a film part available from Toray Industries, Inc. and having a thickness of 0.1 mm with a coating of the ink absorbing layer (having a thickness of 17 µm) on the surface] and the PET film d (available from Toyobo Co. , Ltd. and having a thickness of 0.25 mm without a coating) were prepared as the substrates made of resin.

The flexographic printing press used for the production of the electronic circuit boards in the Inventive and Comparative Examples was used under conditions to be described below (see FIG. 1 and the like for the general configuration of the flexographic printing press).

### [Flexographic Printing Press]

SMART LABO-III® available from Komura-Tech Co., Ltd.

### [Flexographic Printing Plate]

Resin letterpress plate made of polyester rubber available from Komura-Tech Co., Ltd., Type T-YP400V.
Plate thickness: 2.84 mm, 600 lines/inch.
Hardness: 40 to 70 degrees (Shore A hardness).
Ink holding amount of an ink holding part for printing: 4 ml/m² (adjustable range: 1 to 5 ml/m²).

The ink holding part having an electronic circuit pattern with a width of 1 mm is formed on the surface of the printing plate.

### [Anilox Roll]

200 lines/inch (100 to 600 lines/inch).
Cell capacity (cell volume): 8 ml/m² (adjustable range: 1.5 to 50 ml/m²).

### <Flexographic Printing Conditions>

- Printing speed (printing stage travel distance) : 18m/min.
- Anilox roll speed: 25m/min. (peripheral speed).
- Nip width between the anilox roll and the printing plate: 8 mm (adjustable range: 4 to 8 mm).
- Nip width between the printing plate and the substrates: 10 mm (adjustable range: 8 to 12 mm).
- Printing chamber environment (atmosphere): a temperature of 15° to 30°C; and a humidity of 40 to 70% RH.
- Drying conditions after printing: air-drying at a temperature of 23°C (natural drying under atmospheric pressures) for 30 sec. to 60 min.

For acceleration of the drying by blowing warm air, adjustments were made so that the temperature of the warm air and the temperature of the substrates were maintained at 40°C or below.

### [Inventive Example 1]

Under the aforementioned conditions, the nanoink composition was applied once or three or six times in succession in a stacked manner on the same region of the surface (printing surface) of the substrate (photo paper a) byusingthe flexographic printing press and was allowed to stand for 60 minutes at room temperature (23°C) in the atmosphere for air-drying. Thus, the electronic circuit board in "Inventive Example 1" was provided in which an electronic circuit was transferred and formed on the substrate.

### [Inventive Example 2]

The nanoink composition was applied once or three or six times in succession in a stacked manner on the same region of the surface of the substrate by using the flexographic printing press and was allowed to stand for 60 minutes at room temperature (23°C) in the atmosphere in substantially the same manner as in Inventive Example 1 except that the PET film c (with the coating of the ink absorbing layer) was used as the substrate. Thus, the electronic circuit board in "Inventive Example 2" was provided.

### [Comparative Example 1]

The nanoink composition was applied once or three or six times in succession in a stacked manner in the same position on the surface of the substrate by using the flexographic printing press and was allowed to stand for 60 minutes at room temperatures (23°C) in the atmosphere in substantially the same manner as in Inventive Example 1 except that the photo paper b (with a large contact angle of water) was used as the substrate. Thus, the electronic circuit board in "Comparative Example 1" was provided.

### [Comparative Example 2]

The nanoink composition was applied once or three or six times in succession in a stacked manner in the same position on the surface of the substrate by using the flexographic printing press and was allowed to stand for 60 minutes at room temperatures (23°C) in the atmosphere in substantially the same manner as in Inventive Example 1 except that the PET film d (without the ink absorbing layer) was used as the substrate. Thus, the electronic circuit board in "Comparative Example 2" was provided.

### [Comparative Example 3]

Using the PET film c (with the coating of the ink absorbing layer, and an ordinary heat-resistant temperature of 40° to 60°C) as the substrate, the nanoink composition was applied six times in succession on the same region of the surface of the substrate by using the flexographic printing press in substantially the same manner as in Inventive Example 2 to form an electronic circuit on the substrate surface, and this electronic circuit board was placed in an oven with a holding temperature set at 50°C or 60°C for 60 minutes, so that the nanoink composition (stacked ink pattern having a width of 1 mm) was dried. Thus, the electronic circuit board in "Comparative Example 3" was provided.

In the electronic circuit board dried at a temperature of 50°C or 60°C in Comparative Example 3, the entire substrate became wavy due to thermal expansion and contraction, and the formed electronic circuit peeled off to become discontinuous. For this reason, tests to be described later other than "appearance" were not conducted.

"Appearance", "thickness" and "electrically conductive performance" comparisons were made between the electronic circuits (dried ink patterns having a width of 1 mm) formed on the surfaces of the substrates by using the electronic circuit boards in Inventive Examples 1 and 2 and Comparative Examples 1 and 2 described above.

### [Appearance of Electronic Circuits]

Defects such as cracking and chipping in the surface of each of the electronic circuits were visually observed. An electronic circuit having a major defect was evaluated as "F"; an electronic circuit having a defect to such a degree that cracking occurred in the surface thereof was evaluated as "B"; and an electronic circuit in which no defects were observed was evaluated as "A".

### [Thickness of Electronic Circuits]

Each of the electronic circuits together with the substrate was cut in the same position corresponding to near the center of the electronic circuit pattern. The thickness of each of the electronic circuits (the thickness of the dried layer made from the transferred nanoink composition in units of µm) was measured by observing the resultant cross-section under a microscope <JSM-5500 available from JEOL Ltd.>.

### [Electrically Conductive Performance of Electronic Circuits]

The electrical resistance (in units of Ω) between two points (distance: 10 mm) of each of the formed electronic circuits having a width of 1 mm was measured using a digital tester <available from Custom Corporation> in the same position corresponding to near the center of the electronic circuit pattern.

### [Operation Test of Electronic Circuits]

The electronic circuit boards having the electrically conductive performance verified by the test on the aforementioned "electrically conductive performance of electronic circuits" were used. An electronic component such as an IC and an LED was mounted in a predetermined position (bump and the like) of the electronic circuit of each of the aforementioned electronic circuit boards by using an electrically conductive paste (electrically conductive paint of silver and copper known under the trade name of PTP-1202G available from Plascoat Co., Ltd., silver coated copper plus one-liquid type polyester resin binder, dried and cured at ordinary temperatures, organic solvent type). A power supply was connected to the electronic circuit, and the operation as the electronic circuit was tested. As a result, an electronic circuit that operates is indicated by "A", and an electronic circuit that did not operate is indicated by "F".

The results of the aforementioned tests are collectively listed in TABLE 2 below. It should be noted that "--" in TABLE 2 indicates that the tests were not conducted (the electronic circuit boards could not be produced).

**[TABLE 2]**

| | Number of Times of Printing | Appearance evaluation (visual) | Thickness of interconnect line (µm) | Electrical resistance (Ω) | Operation of prototype circuit |
|---|---|---|---|---|---|
| Inv. Ex. 1 (paper a) | 1 | F | 1 or less | -- | -- |
| | 3 | B | 1 | 6.21 | F |
| | 6 | A | 2 | 1.13 | A |
| Inv. Ex. 2 (film c) | 1 | F | 1 or less | 11.5 K | -- |
| | 3 | B | 1 | -- | -- |
| | 6 | A | 2 | 8.60 | A |
| Comp. Ex. 1 (paper b) | 1 | F | 1 or less | -- | -- |
| | 3 | F | 1 or less | -- | -- |
| | 6 | F | 1 or less | -- | -- |
| Comp. Ex. 2 (film d) | 1 | F | 1 or less | -- | -- |
| | 3 | F | 1 or less | -- | -- |
| | 6 | B | 1 or less | 182 K | -- |
| Comp. Ex. 3 (film c) | 6 | F Wavy substrate | -- | -- | -- |

It was found from TABLE 2 that the process of applying the nanoink composition a plurality of times in a stacked manner through the use of the hydrophilic substrate having a surface with the contact angle of water of 30°C or below efficiently provided the electronic circuit board having the electronic circuit with a low electrical resistance without a heating step such as firing.

Although specific forms in the present disclosure have been described in the aforementioned examples, the aforementioned examples should be considered as merely illustrative and not restrictive. It is contemplated that various modifications evident to those skilled in the art could be made without departing from the scope of the present disclosure.

In the electronic circuit board manufacturing method and the electronic circuit board obtained by the same according to the present disclosure, an electronic circuit board including a uniform nanoink composition layer is produced rapidly and efficiently at ordinary temperatures and under atmospheric pressure. Therefore, the manufacturing method according to the present disclosure is capable of forming an electronic circuit made from a nanoink composition on the surface of a substrate even when the substrate is any one selected from not only "heat-sensitive" flexible substrates made of paper, resin or the like, but also substrates having properties degraded by special atmospheres, such as films made of leather, skin, artificial skin, dietary fiber and cellulose nanofiber, animal-derived films produced from microorganisms, bacteria or the like, and films derived from plants such as trees and vegetables.

### REFERENCE SIGNS LIST

- 1: Plate cylinder
- 2: Anilox roll
- 3: Squeegee
- 4: Ink tank
- 11: Printing plate
- 11a: Protrusions
- 11b: Recesses
- S: Movable stage
- W: Workpiece

## Claims

1. A method of manufacturing an electronic circuit board including a substrate and an electronic circuit having a predetermined pattern, the electronic circuit being fixed on the substrate and being made from a nanoink composition containing metal particles, the method comprising the steps of:
holding a nanoink composition containing metal particles on a printing plate, the printing plate including an ink holding part formed on a surface thereof and having a predetermined pattern;
bringing a surface of the substrate into intimate contact with the printing plate to transfer the nanoink composition held on the ink holding part onto the substrate; and
drying the transferred nanoink composition in an environment of 40°C or below in atmospheric pressure to fix the nanoink composition after the transfer step, thereby forming the electronic circuit having the predetermined pattern.

2. The method of manufacturing an electronic circuit board according to claim 1, wherein the substrate is a film made of paper or resin.

3. The method of manufacturing an electronic circuit board according to claim 2, wherein a contact angle of water on the surface of the substrate is not greater than 30 degrees.

4. The method of manufacturing an electronic circuit board according to any one of claims 1 to 3, wherein the content of the metal particles in the nanoink composition is in the range of 0.1 to 20 wt.%.

5. The method of manufacturing an electronic circuit board according to claim 4, wherein the metal particles in the nanoink composition are nanometer-size silver particles.

6. The method of manufacturing an electronic circuit board according to any one of claims 1 to 5, wherein the printing plate is a flexographic printing plate.

7. An electronic circuit board produced by the manufacturing method as recited in any one of claims 1 to 6.
